# EUROPÄISCHE PATENTSCHRIFT

(11) **EP 0 474 637 B1**
(45) Veröffentlichungstag und Bekanntmachung des Hinweises auf die Patenterteilung: **13.08.1997**
(21) Anmeldenummer: 90904761.5
(22) Anmeldetag: 22.03.1990
(51) Int. Cl.: H01L 27/02

(54) **SCHUTZSCHALTUNG GEGEN ÜBERSPANNUNGEN FÜR MOS-BAUELEMENTE**
OVERVOLTAGE PROTECTIVE CIRCUIT FOR MOS COMPONENTS
CIRCUIT DE PROTECTION CONTRE LES SURTENSIONS POUR COMPOSANTS MOS

(30) Priorität: 02.06.1989 DE 3918090
(43) Veröffentlichungstag der Anmeldung: 18.03.1992
(73) Patentinhaber: SIEMENS AKTIENGESELLSCHAFT, 80333 München (DE)
(72) Erfinder: TERLETZKI, Hartmud, W-8012 Ottobrunn (DE)
(86) Internationale Anmeldenummer: DE9000240
(87) Internationale Veröffentlichungsnummer: WO9015440

(56) Entgegenhaltungen:
- EP-A- 0 217 525
- ANNUAL PROCEEDINGS RELIABILITY PHYSICS vol. 24, April 1986, Anaheim, California, USA (IEEE Soc.) Seiten 199 - 205; C. DUVVURY et al.: "ESD PROTECTION RELIABILITY IN 1uM CMOS TECHNOLOGIES" siehe Seite 200, linke Spalte, letzter Absatz Seite 201, linke Spalte, Absatz 2; Figuren 3-5 (in der Anmeldung erwähnt)

## Beschreibung

Die Erfindung betrifft eine Schutzschaltung gegen Überspannungen für MOS-Bauelemente nach dem Oberbegriff des Patentanspruches 1.

Heutige MOS-Bauelemente weisen bei der Fertigung und beim Umgang mit ihnen eine hohe Ausfallrate aufgrund von elektrostatischen Entladungen von Mensch und Maschine auf. Zur Verringerung negativer Auswirkungen dieser elektrostatischen Entladungen, kurz auch ESD (= electrostatic discharge) genannt, gibt es prinzipiell zwei Möglichkeiten. Zum einen kann man für eine potentialfreie Umgebung des MOS-Bauelements sorgen, beispielsweise durch einen Transport desselbigen in speziellen Schaumstoffkörpern oder man entwickelt eine spezielle Schaltung zum Bausteinschutz, die auch auf dem MOS-Bauelement integriert werden kann. Solche Schaltungen schützen dann die empfindlichen Gates der Eingangsstufen der MOS-Bauelemente vor gefährlichen Überspannungen. Ohne einen solchen Bausteinschutz können bereits Spannungen von 20 Volt aufwärts zur Zerstörung des MOS-Bauelements führen, während mit einem Bausteinschutz einige tausend Volt hierfür notwendig werden.

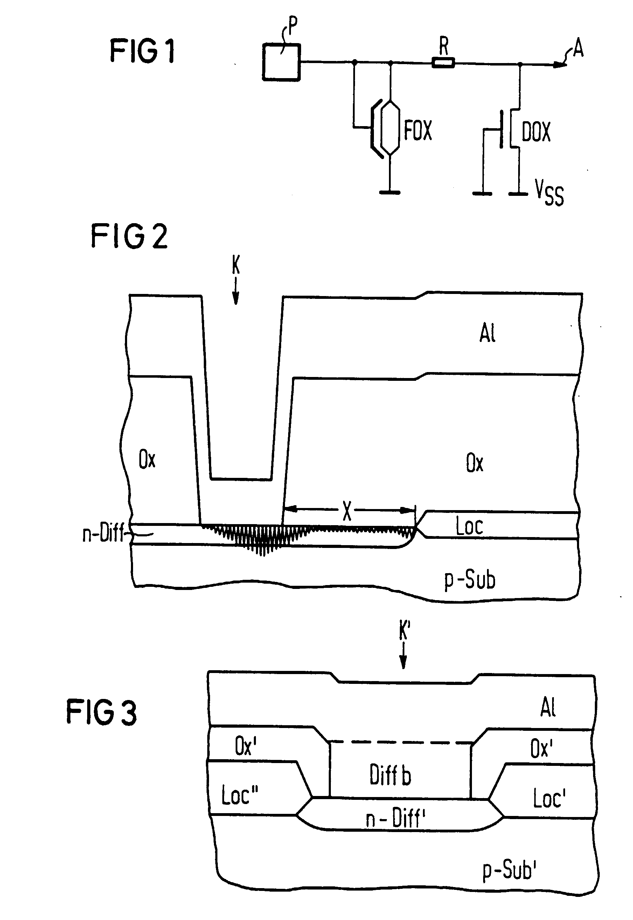

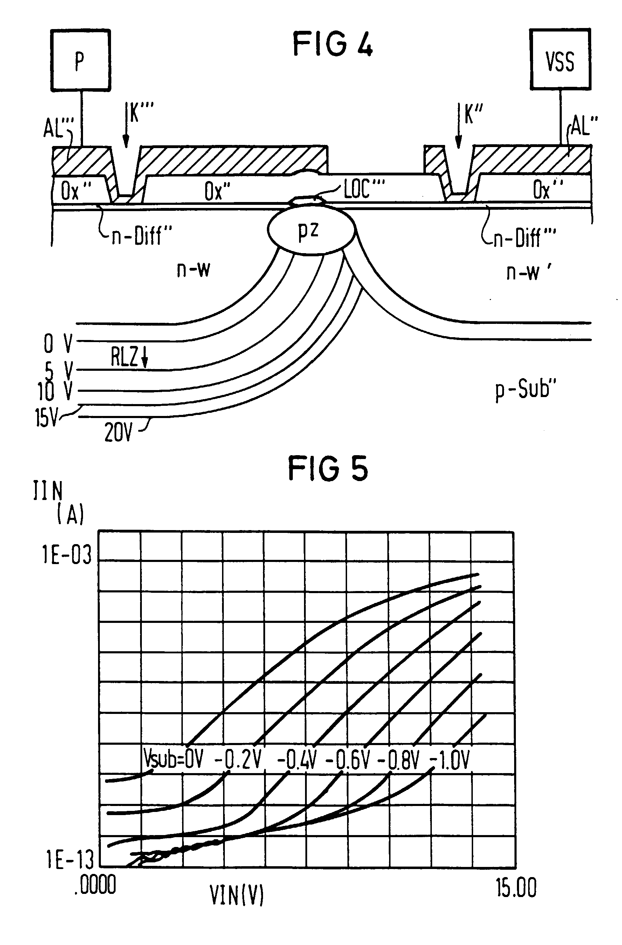

Aus der Veröffentlichung C. Duvvury et al, "ESD Protection Reliability in 1 µm CMOS Technologies", annual, Proc. Reliability Physics Band 24, 1986, ist eine aus einem Dünnoxid-, Feldoxidtransistor und einem Widerstand aufgebaute Schutzschaltung für NMOS- und CMOS-Bauelemente mit Substratvorspannung bekannt. Wie aus der Figurenbeschreibung zu Figur 4 der genannten Veröffentlichung weiter hervorgeht, fällt dem Feldoxidtransistor hierbei eine primäre Schutzfunktion zu, während der Dünnoxidtransistor und Widerstand eine sekundäre Schutzfunktion erfüllen. Der Feldoxidtransistcr arbeitet bei einer ESD-Belastung als ein im Lawinendurchbruch betriebener parasitärer Bipolartransistor und führt die Energie des ESD-Pulses gegen Masse ab. Bei hohen Energie- bzw. Stromdichten können hierbei Temperaturen auftreten, die in der Größenordnung der eutektischen Temperatur (577°C) von Aluminium und Silizium liegen, wobei die Schmelztemperatur von Aluminium 675°C und die von Silizium 1415°C beträgt. Das Aluminium der Leiterbahn legiert dann in das Silizium des Halbleiterkörpers der MOS-Schaltung und verursacht Kurzschlüsse an den n⁺p⁻-Übergängen. Diese als "spiking" bezeichnete Schädigungen führen dann zum Ausfall des MOS-Bauelements. Die negativen Auswirkungen dieser thermischen Schädigung kann für horizontales "spiking" mit Hilfe eines vergrößerten Abstandes des Kontaktloches vom Feldoxidtransistor verringert werden. Mit steigendem Abstand verbessert sich hierbei das ESD-Verhalten des MOS-Bauelements. Dies gilt jedoch nur für entspannte Herstellungsprozesse (zum Beispiel bei einem 2 µm NMOS-Prozeß). Durch Einfügen von Diffusionsbarrieren zwischen den Aluminiumbahnen und den Diffusionsgebieten, läßt sich die ESD-Empfindlichkeit bezüglich vertikalem "spiking" von MOS-Bausteinen verringern. Als Material für diese Diffusionsbarrieren kann beispielsweise Wolfram, Tantalsilizid oder auch Polysilizium herangezogen werden. Dies ist auch aus der Veröffentlichung L. F. DeChiaro, "Input ESD Protection Networks For Fineline NMOS-Effects Of Stressing Waveform And Circuit Layout", Annual. Proc. Realibility Physics, Band 24, 1986, in Figur 1 sowie der zugehörigen Beschreibung zu entnehmen. Zur Durchführung dieser Maßnahmen ist jedoch ein erhöhter Platzbedarf notwendig, der sich bei zunehmender Integration der MOS-Bauelemente als nachteilig herausstellt.

Aus der europäischen Anmeldeschrift EP 0 217 525 ist eine Schutzeinrichtung in Form eines "punch-through"-Elementes bekannt, die am Ausgang einer zu schützenden Schaltung einen Überspannungsschutz bewirkt.

Der Erfindung liegt die Aufgabe zugrunde, eine verbesserte Schutzschaltung gegen Überspannungen für MOS-Bauelemente anzugeben, die möglichst wenig Platz beansprucht und die Überspannung an Eingangs-Anschlüssen sicher gegen ein Bezugspotential ableitet. Weiterhin soll durch die Erfindung das Problem der Ausfälle durch ESD-Belastung bei MOS-Bauelementen reduziert werden.

Diese Aufgaben werden erfindungsgemäß durch die im kennzeichnenden Teil des Patentanspruches 1 angegebenen Merkmale gelöst.

Der Vorteil der erfindungsgemäßen Schutzschaltung mit punchthrough-Element gegenüber herkömmlichen Schutzschaltungen liegt insbesondere darin, daß sie sofort mit Erreichen der punchthrough-Spannung aktiv wird und damit verzögerungsfrei anspricht. Damit wird die Schutzwirkung gerade für sehr steile ESD-Pulse verbessert. Bei Bausteinen mit Substratspannung kann man zusätzlich den Effekt der Substratsteuerung ausnutzen und damit eine Aufladung einzelner Eingangspins während des Umgangs mit dem Baustein vermeiden.

Durch die Wanne unter den Kontaktlöchern wird gleichzeitig das Problem der thermischen Schädigung entschärft. Bei umsymmetrischer Anordnung der n-Wannen zum Feldoxidsteg kann bei kurzer Steglänge die in der Patentanmeldung GR 89 P 1150 DE = P 39 07 523.0 beschriebene Optimierung des parasitären Bipolar-transistors ausgenutzt werden.

Die Patentansprüche 2 bis 7 sind auf eine bevorzugte Ausgestaltung der Schutzschaltung gerichtet, die dort näher erläutert wird.

Die Erfindung wird nachfolgend anhand von Zeichnungen näher beschrieben, es zeigen dabei
- Figur 1: die Schutzschaltung gegen Überspannungen nach dem Stand der Technik, deren prinzipielle Verschaltung auch der erfindungsgemäßen Schutzschaltung zugrundeliegt,
- Figur 2: Querschnitt durch einen Teil eines MOS-Bauelements bei dem durch Überspannungen thermische Schädigungen ("spiking") aufgetreten sind,
- Figur 3: Querschnitt durch einen Teil eines MOS-Bauelements, welches mit zusätzlichen Diffusionsbarrieren ausgestattet ist, um den thermischen Schädigungen vorzubeugen,
- Figur 4: schematische Darstellung des punchthrough-Elements in der erfindungsgemäßen Schutzschaltung,
- Figur 5: Unterschwellverhalten der erfindungsgemäßen Schutzschaltung mit punchthrough-Element und der Substratspannung als Parameter.

Figur 1 zeigt eine Schutzschaltung gegen Überspannungen nach dem Stand der Technik, deren prinzipielle Verschaltung auch in der erfindungsgemäßen Schutzschaltung zum tragen kommt. Sie enthält einen Feldoxidtransistor FOX, einen Dünnoxidtransistor DOX, sowie einen Widerstand R. Die Verschaltung dieser Komponenten ist dabei so vorzunehmen, daß der Sourceanschluß des Feldoxidtransistors FOX, der Sourceanschluß des Dünnoxidtransistors DOX, sowie der Gateanschluß des Dünnoxidtransistors jeweils mit einem Bezugspotential verschaltet ist. Als Bezugspotential wurde in diesem Falle Masse V_{SS} gewählt. Der Gateanschluß, sowie der Drainanschluß des Feldoxidtransistors FOX ist sowohl mit einem Anschluß des Widerstandes R als auch mit einem Eingangspad P des MOS-Bauelements verschaltet. Der andere Anschluß des Widerstandes R ist an den Drainanschluß des Dünnoxidtransistors DOX sowie an einem Anschlußpunkt A der Schutzschaltung angeschlossen. An diesem Anschlußpunkt A können weitere MOS-Bauelemente angeschlossen werden, er selbst dient dabei als Ein- bzw. Ausgang für das zu schützende MOS-Bauelement.

Der als widerstandsbehaftete Diffusionsbahn im Halbleitersilizium ausführbare Widerstand R bildet gemeinsam mit dem Dünnoxidtransistor DOX, der als feldgesteuerte Diode geschaltet ist, ein RC-Tiefpaßglied. Der Widerstand R des RC-Tiefpaßglieds dient zur Strombegrenzung beim Auftreten der Überspannungen, da der Dünnoxidtransistor DOX keine hohen Energien bei einer Überspannung gegen das Bezugspotential V_{SS} abführen kann. Hierfür wird der Feldoxidtransistor FOX eingesetzt, der bei einer ESD-Belastung als ein im Lawinendurchbruch betriebener parasitärer Bipolartransistor arbeitet und die Energie des ESD-Pulses gegen das Bezugspotential abführt.

Bei hohen Energie- bzw. Stromdichten aufgrund der Überspannung können innerhalb des MOS-Bauelements Temperaturen auftreten, die in der Größenordnung der Schmelztemperatur von Aluminium und Silizium liegen. Figur 2 zeigt einen Querschnitt durch einen Teil eines MOS-Bauelements bei dem aufgrund der Überspannungen thermische Schädigungen, auch "spiking" genannt, aufgetreten sind. Durch diese Temperaturen diffundiert das Silizium des Halbleiterkörpers in das Aluminium der Leiterbahn während gleichzeitig das Aluminium in das Silizium des Halbleiterkörpers legiert. Es kommt zu Kurzschlüssen an den n⁺p⁻-Übergängen, die zu einem dauerhaften Ausfall des MOS-Bauelements führen können. Nach Figur 2 ist in das p-leitende Halbleitersubstrat p-Sub ein n⁺-dotiertes Diffusionsgebiet n-Diff eingelagert. Um die späteren aktiven Gebiete untereinander elektrisch zu trennen wird mit Hilfe von örtlich gezielten lokalen Oxidationen nach dem LOCOS-Verfahren (local oxidation of silicon) Isolierschichten Loc erzeugt, wobei eine hiervon in Figur 2 dargestellt ist. Oberhalb dieser Isolierschicht Loc und des n⁺-dotierten Diffusionsgebietes n-Diff ist eine Oxidationsschicht Ox angeordnet, die lediglich innerhalb eines Kontaktgebietes K unterbrochen ist. Oberhalb dieser Oxidationsschicht Ox ist eine Aluminiumschicht Al aufgebracht, die als Leiterbahn eingesetzt wird, und die innerhalb des Kontaktgebietes K eine leitende Verbindung zum n⁺-dotierten Diffusionsgebiet n-Diff herstellt. Weiterhin eingezeichnet in Figur 2 sind die thermischen Schädigungen ("spiking") die sich aufgrund der hohen Energie- bzw. Stromdichten bei Überspannungen ergeben. Das Aluminium der Leiterbahn Al legiert in das p-leitende Halbleitersubstrat p-Sub und verursacht Kurzschlüsse an den n⁺p⁻-Übergängen. Diese führen schließlich zu dem Ausfall des MOS-Bauelements. Wie zu erkennen ist ergeben sich hierbei Maxima unterhalb des Kontaktgebietes K sowie im Bereich des angrenzenden Isolationsgebietes Loc. Im ersten Falle handelt es sich um ein sogenanntes vertikales "spiking" während die zweite thermische Schädigung als horizontales "spiking" bezeichnet wird.

Zur Verringerung des hcrizontalen "spiking" ist es möglich einen vergrößerten Abstand X zwischen dem Kontaktgebiet K und der Isolationsschicht Loc vorzusehen. Mit steigendem Abstand X verbessert sich das ESD-Verhalten von MOS-Bauelementen. Dies gilt jedoch nur für entspannte Prozesse, wie beispielsweise für einen 2 µm NMOS-Prozeß, wobei die kleinste Kanallänge innerhalb der Schaltung 2 µm breit ist. Ziel zukünftiger Entwicklungen für MOS-Bauelemente ist jedoch eine möglichst kleine Kanallänge zu erreichen um die Schaltungen schneller und kleiner zu gestalten. Beispielsweise wird in einem 4-M Speicherbauelement ein 1,0 µm Prozeß eingesetzt.

Figur 3 zeigt den Querschnitt durch einen Teil eines MOS-Bauelements, welches mit zusätzlichen Diffusionsbarrieren ausgerüstet ist um den thermischen Schädigungen insbesondere des vertikalen "spiking" vorzubeugen. Wie aus Figur 3 ersichtlich, ist innerhalb des p-leitenden Halbleitersubstrats p-Sub' ein n⁺-dotiertes Halbleitergebiet n-Dif' eingelagert. Zu beiden Seiten dieses n⁺-dotierten Halbleitergebiets sind Isolierschichten Loc', Loc" angeordnet, die wiederum die späteren aktiven Gebiete untereinander elektrisch trennen. Eine Oxidationsschicht Ox' bedeckt wiederum die Isolierschichten Loc', Loc", sowie Teile der n⁺-dotierten Halbleiterzonen n-Diff'. Unterbrochen wiro diese Oxidationsschicht lediglich innerhalb des Kontaktbereichs K', der mit einer Diffusionsbarriere Diffb aufgefüllt wird. Schließlich bildet eine Aluminiumschicht Al', die die Diffusionsbarriere Diffb, sowie die Oxidationsschicht Ox' gleichermaßen abdeckt den Abschluß der gesamten Anordnung. Als Material für die Diffusionsbarrieren kann beispielsweise Wolfram, Tantalsilizid oder auch Polysilizium eingesetzt werden. Das Material sollte leitfähig und niederohmig sein und keine Schottky-Kontakte an den Übergängen ermöglichen. Durch diese Maßnahme verringert sich die ESD-Empfindlichkeit des MOS-Bauelements insbesondere in bezug auf das vertikale "spiking". Nachteilig ist jedoch hierbei, daß immer dann ein zusätzlicher Prozeß erforderlich ist, wenn die Diffusionsbarriere Diffb zwischen der Aluminiumschicht Al' und der n⁺-dotierten Halbleiterzone n-Diff' mit einer nicht im Herstellungsprozeß enthaltenen Substanz aufgebaut werden soll.

Figur 4 zeigt den erfindungswesentlichen Teil der Schutzschaltung gegen Überspannungen, die grundsätzlich wie in Figur 1 aufgebaut ist. Sie enthält ein punchthrough Element, einen Widerstand sowie einen Dünnoxidtransistor. Um das Problem der Ausfälle integrierter Schaltungen durch ESD-Entladungen zu reduzieren, wird in der erfindungsgemäßen Schutzschaltung gegenüber der Schutzschaltung nach dem Stand der Technik in Figur 1 der Feldoxidtransistor durch ein punchthrough Element ersetzt. Dadurch wird das Problem des verzögerten Ansprechens der Schutzschaltung und die damit verbundene Zerstörung durch Spannungsschäden entschärft. Figur 4 gibt hierbei den Bereich des punchthrough Elements wieder, das unterhalb der Isolierschicht LOC"' und den beiden n⁺-Diffusionsgebieten n-Diff", n-Diff"' angeordnet ist. Für das punchthrough Element sind unterhalb der beiden n⁺-Diffusionsgebiete n-Diff" und n-Diff"' je eine n-wannenförmige Halbleiterzone n-W, n-W' und unterhalb der Isolationsschicht Loc"' eine p-leitende Halbleiterzone PZ eingelagert. Das punchthrough Element selbst wird mit Hilfe von zwei pn-Übergängen aufgebaut, wobei ein erster pn-Übergang sich aus der Grenzfläche zwischen den n-wannenförmigen Halbleiterzone n-W und der p-leitenden Halbleiterzone PZ und der zweite pn-Übergang sich aus der Grenzfläche zwischen der p-leitenden Halbleiterzone PZ und der n-wannenförmigen Halbleiterzone n-W' ergibt. Die beiden wannenförmigen Halbleiterzonen n-W und n-W' sind schwächer n-dotiert als die beiden Diffusionsgebiete n-Diff"' und n-Diff". Die gesamte Anordnung ist auf einem p⁺-dotierten Halbleitersubstrat p-Sub" angeordnet, wobei dieses schwächer dotiert ist als die p-leitende Halbleiterzone PZ. Die Oxidationsschicht OX", die sich oberhalb der Isolierschicht Loc"' und den Diffusionsgebieten n-Diff", n-Diff"' befindet, ist jweils in den Kontaktbereichen K" und K"' unterbrochen um der Aluminiumschicht Al" bzw. Al"' eine Kontaktmöglichkeit zum n⁺-dotierten Diffusionsgebiet zu ermöglichen. Die Aluminiumschicht Al" hat hierbei Kontakt über das Kontaktgebiet K" mit dem n⁺-dotierten Diffusionsgebiet n-Diff"', während die Aluminiumschicht Al"' über das Kontaktgebiet K"' mit dem n⁺-dotierten Diffusionsgebiet n-Diff" kontaktiert ist. Die punchthrough-Spannung ist sowohl durch den Abstand der beiden unter den Kontaktgebieten K" und K"' angeordneten n-wannenförmigen Halbleiterzonen, als auch durch die angelegte Sperrspannung am Eingangspad P und durch eine Substratspannung festgelegt. Durch eine geeignete Dimensionierung des Abstandes beider n-wannenförmigen Halbleiterzonen kann somit erreicht werden, daß die Schutzschaltung bereits vor dem Auftreten einer unerwünscht hohen Durchbruchsspannung aktiviert wird. Im Normalbetrieb darf jedoch keine Berührung der Raumladungszonen stattfinden. Wie in Figur 1 ist das punchthrough Element mit seinem Drainanschluß (n-wannenförmige Halbleiterzone n-W des punchthrough Elements) mit dem Eingangspad P des zu schützenden MOS-Bauelements verbunden, während der Sourceanschluß (n-wannenförmige Halbleiterzone n-W' des punchthrough Elements) mit dem Bezugspotential, in diesem Falle an Masse VSS anzuschließen ist. Daher ist die Aluminiumschicht Al" mit VSS und die Aluminiumschicht Al"' mit dem Anschluß P des MOS-Bauelements zu verbinden.

Die folgenden Ausführungen sollen beitragen helfen, die Wirkungsweise der erfindungsgemäßen Schutzschaltung mit dem punchthrough Element verständlicher zu machen. Durch die Spannungsrampe des ESD-Entladepusles dehnt sich die Raumladungszone des in Sperrichtung gepolten drainseitigen pn-Übergangs aus, bis sich die beiden Raumladungszonen der n-wannenförmigen Halbleiterzone berühren. Dies wird in der Figur 4 durch einen Pfeil mit dem Bezugszeichen RLZ für steigende Spannungen des ESD-Endladepulses verdeutlicht. Die Angaben über die Spannungen des ESD-Endladepulses von 0 Volt, 5 Volt, 10 Volt, 15 Volt und 20 Volt mit den zugehörigen Ausbreitungslinien der Raumladungszonen dienen zur Darstellung der Veränderungen der Raumladungszonen bei ansteigender Spannung des ESD-Entladepulses. Wie weiter zu erkennen ist, sind beide n-wannenförmigen Halbleiterzonen n-W und n-W' auch bei keinem ESD-Endladepulses (0 Volt Ausbreitungslinie der Raumladungszone) je von einer Raumladungszone umgeben. Eine Ausdehnung der Raumladungszone erfolgt parallel mit dem Anstieg der ESD-Spannung ohne zeitliche Verzögerung. Sobald sich beide Raumladungszonen berühren, wird das interne elektrische Feld der sourceseitigen Sperrschicht durch die von außen angelegte Spannung geschwächt, so daß ein Transport freier Ladungsträger von VSS (gleich Masse) zum Eingangspad P einsetzt. Die Berührung der Raumladungszonen und den damit einsetzenden Stromfluß bezeichnet man als "punchthrough".

Der Strom steigt dann exponentiell an. Sobald die punchthrough-Spannung erreicht ist, verringert sich der Eingangswiderstand der erfindungsgemäßen Schutzschaltung, wodurch der ESD-Entladepuls in seinem Anstieg gedämpft wird. Der Eingangswiderstand wird jedoch nicht so niederohmig, daß ein weiterer Anstieg der ESD-Spannung verhindert wird. Die Spannung am Eingangspad P steigt weiter, bis der Lawinendurchbruch des in Sperrichtung betriebenen pn-Übergangs einsetzt und der parasitäre npn-Bipolartransistor des punchthrough-Elements in den sogenannten "Snapback" Zustand übergeht. Siehe hierzu auch die Veröffentlichung von T. Toyabl "A numerical model of avalanche breakdown in MOSFET's", Electron Devices, Vol. ED-25, No. 7, 1978, auf den Seiten 825 bis 832. Erst jetzt entsteht der niederohmige Spannungspfad gegen Masse (VSS), der die Energie des ESD-Endladepulses abführt.

Diese erfindungsgemäße Schaltung eignet sich besonders für Bausteine, die eine Substratspannung während des Betriebs benötigen, wie dies beispielsweise für dynamische Speicher der Fall ist. Durch die Substratspannung wird die Feldstärke des sourceseitigen pn-Übergangs erhöht. Diese Erhöhung der Feldstärke bewirkt, daß die punchthrough-Spannung im Betrieb zu einem höheren Wert verschoben wird. Wenn man diesen Effekt einer "Substratsteuerung" ausnützt, kann man die n-Wannen so plazieren, daß die punchthrough-Spannung ohne Substratspannung bei etwa 0 Volt liegt und mit Substratspannung zu einem Wert verschoben wird, der oberhalb der Betriebsspannung liegt. Damit sind alle Eingänge einer Schaltung im offenen Betriebszustand über die Masseverbindung "niederohmig" miteinander verbunden.

Eine elektrostatische Aufladung einzelner Eingangspins während der Berührung der Bausteine ist nun nicht mehr möglich. Eventuell können hierbei sogar die umständlichen und teueren leitfähigen Schaumstoffe, die für den Transport ESD gefährdeter Bausteine nötig sind, eingespart werden.

Als beispielhafte Angaben für die Dimensionierung der Dotierungshöhe und der Abmessungen können folgende Angaben gesehen werden. Die n⁺-Diffusionsgebiete n-Diff" sowie n-Diff"' sollten eine Dotierungshöhe von größer als 10²⁰ cm⁻³, die niedrig dotierte n-Wannen n-W und n-W' hingegen 4 bis 5 . 10¹⁶ cm⁻³ aufweisen. Das p-leitende Substrat p-Sub" des Halbleiterkörpers könnte eine Dotierungsstoffkonzentration von 2 bis 3 . 10¹⁵ cm⁻³ haben, während hingegen die p-leitende Halbleiterzone PZ mit einer Dotierungshöhe von 1 x 10¹⁷ cm⁻³ ausgebildet werden könnte. Die n-Wannen nach Figur 4 sind in ihrer Ausbildung 4 pm tief ausgestaltet. Zur Dimensionierung der übrigen Bauelemente der Schutzschaltung, wie des Widerstandes R, sowie des Dünnoxidtransistors DOX, die wie in Figur 1 angegeben verschaltet werden, können folgende Angaben gemacht werden. Der Diffusionswiderstand sollte einen Wert von 1 kOhm nicht überschreiten, während der als feldgesteuerte Diode geschaltete Dünnoxidtransistor DOX eine Kanallänge aufweisen sollte, die ungefähr um den Faktor 0,2 größer zu wählen ist, als die minimale Kanallänge des eingesetzten Prozesses. bei einem beispielhaften 1 µm Prozeß ist somit die Kanallänge mit 1,2 µm zu dimensionieren. Die Kanalweite für diesen Transistor sollte zwischen 40 und 60 µm liegen.

Die gesamte Schutzschaltung kann auch in komplementärer Schaltungstechnologie aufgebaut werden, hierzu sind lediglich seine p- und n-Gebiete zu tauschen, die grundsätzliche Verschaltung bleibt hiervon unberührt.

Figur 5 zeigt das Unterschwellverhalten der erfindungsgemäßen Eingangsschutzschaltung mit punchthrough-Element und der Substratspannung als Parameter. Als Unterschwellverhalten bezeichnet man die Stromcharakteristik eines Bauelements im unteren Strombereich zwischen 1 . 10⁻¹² A bis 1 . 10⁻³ A. Wie bereits angegeben führt eine Erhöhung der Feldstärke aufgrund einer vorhandenen Substratspannung dazu, daß die punchthrough-Spannung im Betrieb zu einem höheren Wert verschoben wird. In Figur 5 ist hierzu auf der horizontalen Achse die Eingangsspannung VIN und auf der vertikalen Achse der Eingangsstrom IIN aufgetragen. Als Maßstab wurde für die Eingangsspannung VIN 1,5 Volt pro Rasterfeld gewählt, so daß Eingangsspannungen zwischen 0 und 15 Volt darstellbar sind. Der Eingangsstrom IIN liegt zwischen 1 x 10⁻¹³ Ampere bis zu 1 x 10⁻³ Ampere und ist logarithmisch aufgetragen. Das Unterschwellverhalten wird in Figur 5 für eine Substratspannung Vsub von 0 Volt, - 0,2 Volt, - 0,4 Volt, -0,6 Volt, - 0,8 Volt und - 1,0 Volt als Parameter dargestellt. Als punchthrough-Spannung,bei einem Eingangsstrom beispielsweise von 1 . 10⁻⁶ A und einer Substratspannung Vsub = 0 Volt (keine Substratspannung),ergibt sich aus Figur 5 eine Spannung von etwa 7 Volt. Diese punchthrough-Spannung erhöht sich beim Anlegen einer Substratspannung von beispielsweise Vsub = - 0,6 V auf etwa 13 Volt. Durch eine Verringerung des Abstandes beider n-wannenförmiger Halbleiterzonen verschiebt sich die Kurvenschar zu geringeren punchthrough-Spannungen und damit zu höheren Eingangsströmen. Dies entspricht einer Parallelverschiebung der Kurvenschar in Figur 5 nach links. Die n-wannenförmigen Halbleiterzonen können nun so plaziert werden, daß die punchthrough-Spannung ohne Substratspannung Vsub bei etwa 0 Volt liegt und mit einer Substratspannung Vsub auf einen Wert verschoben wird, der oberhalb der Betriebsspannung liegt. Damit sind alle Eingänge einer zu schützenden Schaltung im offenen Betriebszustand (= Baustein im spannungslosen Zustand) über die Masseleitung niederohmig miteinander verbunden.

## Patentansprüche

1. Schutzschaltung gegen Überspannung für MOS-Bauelemente die ein Schutzelement, einen Dünnoxidtransistor (DOX) und einen Widerstand (R) enthält, wobei ein erstes Diffusionsgebiet (n-Diff"') ersten Leitungstyps ein Sourcegebiet und ein zweites Diffusionsgebiet (n-Diff") ersten Leitungstyps ein Draingebiet bilden, das erste Diffusionsgebiet (n-Diff"') mit einem ersten Anschluß des Schutzelements, das zweite Diffusionsgebiet (n-Diff") mit einem zweiten Anschluß des Schutzelementes verbunden ist und eine Isolierschicht (LOC"') das erste und zweite Diffusionsgebiet (n-Diff"', n-Diff") voneinander trennt und bei dem der erste Anschluß des Schutzelements, ein erster Anschluß und ein Gateanschluß jeweils des Dünnoxidtransistors (DOX) mit einem gemeinsamen Bezugspotential verschaltet sind und bei dem ein erster Anschluß des Widerstandes (R), und der zweite Anschluß des Schutzelements mit einem Eingangs-Anschluß (P) des MOS-Bauelements verschaltet ist, und ein zweiter Anschluß des Widerstandes (R) mit einem zweiten Anschluß des Dünnoxidtransistors (DOX) und mit einem Anschlußpunkt (A) der Schutzschaltung verbunden ist, **dadurch gekennzeichnet**, daß das Schutzelement unterhalb der Isolierschicht (LOC"') und unterhalb des ersten und zweiten Diffusionsgebietes (n-Diff"', n-Diff") angeordnet ist, daß unterhalb des ersten hoch dotierten Diffusionsgebietes (n-Diff"') eine erste wannenförmig ausgebildete niedrig dotierte Halbleiterzone (n-W') ersten Leitungstyps, unterhalb des zweiten hoch dotierten Diffusionsgebietes (n-Diff") eine zweite wannenförmig ausgebildete niedrig dotierte Halbleiterzone (n-W) ersten Leitungstyps und unterhalb der Isolierschicht (LOC"') eine Halbleiterzone (PZ) zweiten Leitungstyps angeordnet ist, daß ein erster pn-Übergang zwischen der ersten wannenförmig ausgebildeten Halbleiterzone (n-W') ersten Leitungstyps und der Halbleiterzone (PZ) zweiten Leitungstyps und ein zweiter pn-Übergang zwischen der zweiten wannenförmig ausgebildeten Halbleiterzone (n-W) ersten Leitungstyps und der Halbleiterzone (PZ) zweiten Leitungstyps das Schutzelement in Form eines punch-through-Elements bilden und daß ein dritter pn-Übergang zwischen dem ersten Diffusionsgebiet und der Halbleiterzone des zweiten Leitungstyps und ein vierter pn-Überganz zwischen dem zweiten Diffusionsgebiet und der Halbleiterzone des zweiten Leitungstyps vorgesehen sind.

2. Schutzschaltung gegen Überspannungen nach Anspruch 1, **dadurch gekennzeichnet**, daß die Schutzschaltung in n-well-Technologie ausgebildet ist, daß die erste und zweite wannenförmig ausgebildete Halbleiterzone (n-W, n-W'), das erste und zweite Diffusionsgebiet (n-Diff"', n-Diff") n-dotiert und die Halbleiterzone zweiten Leitungstyps (PZ) und das Halbleitersubstrat (p-Sub'') p-dotiert sind.

3. Schutzschaltung gegen Überspannungen nach Anspruch 1, **dadurch gekennzeichnet**, daß die Schutzschaltung in p-well-Technologie ausgebildet ist, daß die erste und zweite wannenförmig ausgebildete Halbleiterzone (n-W, n-W'), das erste und zweite Diffusionsgebiet (n-Diff"', n-Diff") p-dotiert und die Halbleiterzone zweiten Leitungstyps (PZ) und das Halbleitersubstrat (p-Sub'') n-dotiert sind.

4. Schutzschaltung gegen Überspannungen nach einem der Ansprüche 1 bis 3, **dadurch gekennzeichnet**, daß der Widerstand (R) als widerstandsbehaftete Diffusionsbahn realisiert ist.

5. Schutzschaltung gegen Überspannungen nach einem der Ansprüche 1 bis 4, **dadurch gekennzeichnet**, daß die Schutzschaltung mit dem zu schützenden MOS-Bauelement auf einem Halbleitersubstrat integriert ist.

## Claims

1. Circuit for protecting MOS components against overvoltage, which contains a protective element, a thin-oxide transistor (DOX) and a resistor (R), a first diffusion region (n-Diff"') of a first type of conduction forming a source region and a second diffusion region (n-Diff'') of a first type of conduction forming a drain region, the first diffusion region (n-Diff"') being connected to a first terminal of the protective element, the second diffusion region (n-Diff'') being connected to a second terminal of the protective element and an insulating layer (LOC"') separating the first and second diffusion region (n-Diff''', n-Diff'') from one another and in which the first terminal of the protective element, a first terminal and a gate terminal in each case of the thin-oxide transistor (DOX) are connected to a common reference potential and in which a first terminal of the resistor (R) and the second terminal of the protective element are connected to an input terminal (P) of the MOS component, and a second terminal of the resistor (R) is connected to a second terminal of the thin-oxide transistor (DOX) and to a connection point (A) of the protective circuit, characterized in that the protective element is arranged below the insulating layer (LOC"') and below the first and second diffusion region (n-Diff"', n-Diff"), in that a first lightly doped semiconductor zone (n-W') of the first type of conduction, constructed to be well-shaped, is arranged below the first heavily doped diffusion region (n-Diff'''), a second lightly doped semiconductor zone (n-W) of the first type of conduction, constructed to be well-shaped, is arranged below the second heavily doped diffusion region (n-Diff'') and a semiconductor zone (PZ) of the second type of conduction is arranged below the insulating layer (LOC"'), in that a first pn junction between the first semiconductor zone (n-W') of the first type of conduction, constructed to be well-shaped, and the semiconductor zone (PZ) of the second type of conduction and a second pn junction between the second semiconductor zone (n-W) of the first type of conduction, constructed to be well-shaped, and the semiconductor zone (PZ) of the second type of conduction form the protective element in the form of a punch-through element and in that a third pn junction is provided between the first diffusion region and the semiconductor zone of the second type of conduction and a fourth pn junction is provided between the second diffusion region and the semiconductor zone of the second type of conduction.

2. Circuit for protecting against overvoltages according to Claim 1, characterized in that the protective circuit is constructed in n-well technology, the first and second semiconductor zone (n-W, n-W'), constructed to be well-shaped, and the first and second diffusion region and (n-Diff''', n-Diff'') are n-doped and the semiconductor zone of the second type of conduction (PZ) and the semiconductor substrate (p-Sub") are p-doped.

3. Circuit for protecting against overvoltages according to Claim 1, characterized in that the protective circuit is constructed in p-well technology, the first and second semiconductor zone (n-W, n-W'), constructed to be well-shaped, and the first and second diffusion region (n-Diff"', n-Diff'') are p-doped and the semiconductor zone of the second type of conduction (PZ) and the semiconductor substrate (p-Sub") are n-doped.

4. Circuit for protecting against overvoltages according to one of Claims 1 to 3, characterized in that the resistor (R) is implemented as resistive diffusion track.

5. Circuit for protecting against overvoltages according to one of Claims 1 to 4, characterized in that the protective circuit is integrated with the MOS component to be protected on one semiconductor substrate.

## Revendications

1. Circuit de protection contre les surtensions pour composants MOS, qui comporte un élément de protection, un transistor à oxyde mince (DOX) et une résistance (R), une première zone de diffusion (n-Diff"') d'un premier type de conductivité formant une zone-source et une seconde zone de diffusion (n-Diff") d'un premier type de conductivité, une zone de drain, la première zone de diffusion (n-Diff"') étant reliée à une première borne de l'élément de protection, la seconde zone de diffusion (n-Diff") étant reliée à une seconde borne de l'élément de protection et une couche isolante (LOC"') séparant la première zone de diffusion de la seconde (n-Diff"', n-Diff") et dans lequel la première borne de l'élément de protection, une première borne et une borne de grille du transistor à oxyde mince (DOX) sont câblées respectivement à un potentiel de référence commun et dans lequel une première borne de la résistance (R) et la seconde borne de l'élément de protection sont câblées à une borne d'entrée (P) du composant MOS, et une seconde borne de la résistance (R) est reliée à la seconde borne du transistor à oxyde mince (DOX) et à un point de raccordement (A) du circuit de protection, **caractérisée en ce que**, l'élément protecteur est disposé en dessous de la couche isolante (LOC"') et en dessous de la première et de la seconde zone de diffusion (n-Diff"', n-Diff"), en ce qu'une première zone semi-conductrice (n-W') du premier type de conductivité, faiblement dopée, réalisée en forme de cuvette, est disposée sous la première zone de diffusion (n-Diff"') fortement dopée, une seconde zone semi-conductrice (n-W) du premier type de conductivité, faiblement dopée, réalisée en forme de cuvette, est disposée sous la seconde zone de diffusion (n-Diff") fortement dopée et une zone semi-conductrice (PZ) du deuxième type de conductivité est disposée sous la couche isolante (LOC"'), en ce qu'une première jonction pn entre la première zone semi-conductrice (n-W') du premier type de conductivité réalisée en forme de cuvette et la zone semi-conductrice (PZ) du second type de conductivité et une seconde jonction pn entre la seconde zone semi-conductrice (n-W) du premier type de conductivité réalisée en forme de cuvette et la zone semi-conductrice (PZ) du second type de conductivité forment l'élément de protection sous forme d'un élément "punchthrough" et en ce qu'une troisième jonction pn entre la première zone de diffusion et la zone semi-conductrice du second type de conductivité et une quatrième jonction pn entre la seconde zone de diffusion et la zone semi-conductrice du second type de conductivité sont prévues.

2. Circuit de protection contre les surtensions selon la revendication 1, caractérisé en ce que le circuit de protection est réalisé en technologie n-well, en ce que la première et la seconde zone semi-conductrice réalisée en forme de cuvette (n-W, n-W'), la première et la seconde zone de diffusion (n-Diff"', n-Diff") sont dopées n et en ce que la zone semi-conductrice du second type de conductivité (PZ) et le substrat semi-conducteur (p-Sub") sont dopés p.

3. Circuit de protection contre les surtensions selon la revendication 1, caractérisé en ce que le circuit de protection est réalisé en technologie p-well, en ce que la première et la seconde zone semi-conductrice (n-W, n-W') réalisées en forme de cuvette, la première et la seconde zone de diffusion (n-Diff"', n-Diff") sont dopées p et en ce que la zone semi-conductrice du second type de conductivité (PZ) et le substrat semi-conducteur (P-Sub") sont dopés n.

4. Circuit de protection contre les surtensions selon l'une des revendications 1 à 3, caractérisé en ce que la résistance(R) est réalisée comme voie de diffusion dotée d'une résistance.

5. Circuit de protection contre les surtensions selon l'une des revendications 1 à 4, caractérisé en ce que le circuit de protection est intégré à un substrat semi-conducteur avec le composant MOS à protéger.
